# FASCICULE DE BREVET EUROPEEN

(11) **EP 0 298 865 B1**
(45) Date de publication et mention de la délivrance du brevet: **21.09.1994**
(21) Numéro de dépôt: 88401765.8
(22) Date de dépôt: 06.07.1988
(51) Int. Cl.: G01R 31/00, G01R 27/14

(54) **Système automatique de tests d'endurance d'une pluralité d'éléments électriques conducteurs**
Automatische Anordnung zur Ausdauerprüfung einer Vielzahl elektrisch leitender Elemente
Automatic system for the endurance-testing of a plurality of electrical conducting elements

(30) Priorité: 09.07.1987 FR 8709744
(43) Date de publication de la demande: 11.01.1989
(73) Titulaire: COMMISSARIAT A L'ENERGIE ATOMIQUE, 75015 Paris Cédex 15 (FR)
(72) Inventeur: Toffoli, Alain, F-38450 Vif (FR)
(74) Mandataire: Signore, Robert

(56) Documents cités:
- EP-A- 0 171 563
- EP-A- 0 253 746
- DE-A- 3 017 827
- DE-A- 3 105 491
- FR-A- 2 400 208
- GB-A- 2 090 002
- US-A- 4 063 027
- IEEE TRANSACTIONS ON PARTS, HYBRIDS, AND PACKAGING, vol. PHP-13, no. 1, mars1977, pages 51-60; New York, US; J.J: BRADY: "Anomalous behavior of reed relaysunder accelerated life-test conditions"
- 35TH IEEE ELECTRONIC COMPONENTS CONFERENCE, Washington DC, 20-22 mai 1985,pages 294-297, IEEE, US; D.D. CHANG et al.: "Multilayer ceramic capacitoraccelerated life test system"
- LANDIS & GYR MITTEILUNGEN, vol. 23,no. 2, février 1976, pages 16-19, Zug, CH; W. SCHÄFER: "AutomatischeMesswerterfassung und Versuchsauswertung im Quality Control"

## Description

La présente invention concerne un système automatique de tests d'endurance d'une pluralité d'éléments électriques conducteurs. Elle s'applique notamment à des tests d'endurance d'éléments électriques résistifs pour lesquels il est nécessaire de connaître les durées des périodes à la fin desquelles ces éléments sont détruits. La destruction de chaque élément est repérée par la variation brusque de la valeur du courant qui circule dans cet élément.

De façon avantageuse pour accélérer les tests d'endurance des éléments à tester, on fait subir auxdits éléments des contraintes en température et on leur applique une densité de courant supérieure à celle qu'ils peuvent supporter.

On sait actuellement réaliser des tests d'endurance d'éléments électriques conducteurs, notamment en faisant circuler un courant continu dans chacun de ces éléments, en le reliant à un générateur de courant continu ; on mesure la tension ou le courant appliqué à cet élément de manière à déterminer la durée de la période qui s'écoule entre le début du passage du courant dans cet élément, et l'instant pour lequel le courant qui lui est appliqué chute ; cette chute indique la destruction de cet élément. Des systèmes de tests de ce type sont décrits dans les documents :
- IEEE TRANSACTIONS ON PARTS, HYBRIDS, AND PACKAGING, vol. PHP-13, no. 1, mars 1977, pages 51-60; New York, U.S.: J.J.Brady: "Anomalous behavior of reed relays under accelerated life-test conditions".
- 35TH IEEE ELECTRONIC COMPONENTS CONFERENCE, Washington DC, 20-22 mai 1985, pages 294-297, IEEE, US; D.D.CHANG et al.: "Multilayer ceramic capacitor accelerated life test system".

On sait aussi effectuer un test d'endurance d'un groupe d'éléments électriques conducteurs reliés en série ou en parallèle, en faisant circuler un courant continu de valeur prédéterminée dans ces éléments groupés. On mesure le courant total circulant dans ces éléments. Le changement de la valeur du courant mesuré indique la destruction d'un ou plusieurs des éléments du groupe. Lorsque les éléments sont reliés en série, pour assurer la continuité du circuit alimenté par le générateur de courant, on relie en parallèle avec chaque élément, par exemple une diode de Zener qui permet d'assurer la continuité de circulation du courant lorsque l'un des éléments du groupe est détruit.

Dans l'état actuel de la technique, chaque élément ou chaque groupe d'éléments à tester doit être alimenté par un générateur et les mesures de courants ou de tension ainsi que le réglage des valeurs des courants fournis par les générateurs aux différents éléments ou différents groupes ne sont pas réalisés automatiquement, les tests sont donc très longs et par conséquent très coûteux.

De plus, il peut être utile pour des tests d'endurance, d'alimenter des éléments ou des groupes d'éléments par des créneaux de courant présentant des fréquences et des rapports cycliques sélectionnés en fonction de chaque élément ou chaque groupe d'éléments. En effet, certains éléments étant destinés à fonctionner en courant alternatif, il est plus avantageux de tester ces éléments avec des créneaux de courant. Il peut être également utile d'automatiser les tests de plusieurs éléments ou de plusieurs groupes d'éléments, en réglant pour chacun d'eux des valeurs différentes de fréquences ou des rapports cycliques des créneaux de courant qui leur sont appliqués. Malheureusement, on ne sait pas actuellement effectuer des tests automatisés d'endurance d'une pluralité d'éléments ou de groupes d'éléments alimentés respectivement par différents générateurs leur appliquant des créneaux de courant dont on peut régler les fréquences et les rapports cycliques séparément et automatiquement.

L'invention a pour but de remédier à ces inconvénients et notamment d'automatiser les tests d'endurance d'une pluralité d'éléments électriques conducteurs ou d'une pluralité de groupes de ces éléments, en utilisant des générateurs réglables appliquant à ces éléments ou ces groupes d'éléments des courants continus de valeurs réglables ou des créneaux de courants ayant des fréquences des rapports cycliques et des valeurs réglables ; les courants continus ou en créneaux peuvent être appliqués indépendamment à chaque élément ou groupe d'éléments.

L'invention a pour objet un système automatique de tests d'endurance d'une pluralité d'éléments électriques conducteurs, ces éléments pouvant être séparés les uns des autres ou connectés entre eux pour former un ou plusieurs groupes séparés d'éléments de ladite pluralité, comportant pour chaque élément ou chaque groupe un générateur réglable de courant relié à cet élément ou à ce groupe pour lui appliquer à partir d'un instant prédéterminé de départ, un courant de valeur prédéterminée réglable et, pour ces éléments ou ces groupes d'éléments, des moyens de mesure des valeurs des courants et/ou des valeurs de tensions appliqués à ces éléments ou ces groupes d'éléments pour déterminer les évolutions respectives de ces valeurs au cours du temps, à partir des instants respectifs prédéterminés jusqu'à des instants respectifs caractéristiques auxquels se produisent respectivement des variations de ces valeurs, caractérisé en ce qu'il comporte un processeur relié à une mémoire, aux moyens de mesure et aux générateurs correspondant respectivement aux éléments ou aux groupes d'éléments, la mémoire contenant des données de réglage des valeurs des courants fournis par les générateurs, des informations d'adressage de ces générateurs et de commande des moyens de mesure pour permettre la mesure et l'enregistrement dans la mémoire de valeurs évolutives des courants et/ou des tension mesurés respectivement pour ces éléments ou groupes d'éléments depuis les instants prédéterminés jusqu'auxdits instants caractéristiques respectifs, les courants appliqués aux éléments ou groupes d'éléments pouvant être continus ou en créneau, lesdits instants caractéristiques étant déterminés par le processeur qui détecte une variation entre des valeurs de courants et/ou de tensions mémorisées dans la mémoire et les valeurs des courants et/ou de tensions fournies directement par les moyens de lecture et/ou de mesure. Les mesures de courant et/ou de tension sont effectuées de préférence uniquement en courant continu pour des raisons de fiabilité des mesures et de coût des appareils de mesure. Selon l'invention, l'ensemble des générateurs comporte :
- au moins un générateur réglable de créneaux relié au processeur pour recevoir des informations d'adressage et des données de réglage de la fréquence et du rapport cyclique des créneaux sélectionnés, et chaque générateur comprend :
- une mémoire de courant contenant des données correspondant à la valeur de courant prédéterminée que l'on souhaite appliquer à l'élément ou au groupe correspondant, cette mémoire étant reliée au processeur pour recevoir des informations d'adressage et des données correspondant à la valeur de courant,
- un circuit logique ayant des entrées respectivement reliées à des sorties de la mémoire de courant pour recevoir lesdites données correspondant à la valeur du courant continu souhaité et relié à une sortie du générateur de créneaux pour recevoir les créneaux sélectionnés, ce circuit logique fournissant sur des sorties les données correspondant à la valeur du courant, soit en continu, soit en créneau, suivant l'état des sorties du générateur de créneau,
- un convertisseur numérique-analogique relié à des sorties du circuit logique pour fournir sur une sortie, soit un courant continu de valeur souhaitée, soit des créneaux sélectionnés de courant de valeur souhaitée,
- un adaptateur d'impédance relié par une entrée à la sortie du convertisseur et relié par une sortie à l'élément ou au groupe correspondant pour lui appliquer le courant continu de valeur souhaitée ou les créneaux sélectionnés de valeur souhaitée.

Selon les tests d'endurance appliqués à des éléments électriques, le système peut comporter un seul générateur de créneaux pour l'ensemble des générateurs de courants ou bien il peut comporter des générateurs de créneaux pour chaque générateur de courant. Lorsqu'un seul générateur de créneaux est utilisé, les fréquences et les rapports cycliques des créneaux générés sont les mêmes pour tous les éléments ou groupe d'éléments testés mais les courants de crête peuvent être différents puisqu'ils dépendent des valeurs mémorisées dans les mémoires de courants.

Selon une autre caractéristique, chaque élément ou groupe d'éléments est relié à la sortie de l'adaptateur d'impédance par un commutateur de sécurité qui, dans une première position, relie la sortie de l'adaptateur à une source de haute tension, pendant la mise en place de l'élément ou groupe d'éléments qui doit être relié à la source de haute tension et à la sortie de l'adaptateur pour un test, ce commutateur de sécurité reliant, dans une deuxième position, la sortie de l'adaptateur avec l'élément ou groupe d'éléments, au moment du test, et étant lui-même relié à une sortie de commande du processeur pour recevoir des signaux de commande le plaçant dans la première ou la deuxième position, ces signaux correspondant à des informations enregistrées dans la mémoire du processeur.

Selon une autre caractéristique, l'adaptateur d'impédance comprend un amplificateur relié à la sortie du convertisseur numérique-analogique et à la base d'un transistor dont une première électrode est reliée au commutateur de sécurité et constitue la sortie de l'adaptateur d'impédance, une deuxième électrode de ce transistor étant reliée à une masse de référence par des moyens de calibrage du courant circulant dans le transistor et dans l'élément ou groupe d'éléments correspondant.

Selon une autre caractéristique, les moyens de calibrage comportent un commutateur de sélection de calibre dont une première borne est reliée à la première électrode, ce commutateur ayant deux autres bornes de calibrage reliées respectivement à des résistances de calibrage elles-mêmes reliées à la tension de référence, le commutateur de sélection étant relié par une entrée de commande à une sortie du processeur pour recevoir un signal de commande de sélection de l'une des résistances de calibrage, ce signal de commande de sélection correspondant à des informations enregistrées dans la mémoire du processeur.

De façon avantageuse, le système comprend des moyens de lecture de courant à entrées de mesures analogiques reliées respectivement aux premières bornes des moyens de calibrage correspondant aux éléments ou groupes d'éléments, ces moyens ayant une sortie numérique et une entrée de commande reliées au processeur, cette entrée de commande recevant des signaux de sélection pour mesurer successivement les valeurs des courants respectifs cycliques aux éléments ou groupes d'éléments.

Selon une autre caractéristique les moyens de mesures de tension comportent un voltmètre à entrées de mesure analogiques, relié à chaque élément par l'intermédiaire d'un commutateur à balayage ayant une entrée de commande reliée au processeur, cette entrée recevant des signaux de sélection d'un élément pour relier le voltmètre successivement aux bornes des différents éléments, ledit voltmètre comporte une sortie numérique reliée au processeur, pour enregistrer successivement les valeurs de tension mesurées aux bornes de chaque élément, une horloge interne du processeur permettant d'enregistrer ledit instant prédéterminé de départ et des instants de mesure de tension pour chaque élément afin de permettre au processeur de déterminer l'instant prédéterminé caractéristique pour chaque élément.

Les caractéristiques et avantages de l'invention ressortiront mieux de la description qui va suivre, donnée en référence aux dessins annexés dans lesquels :
- les figures 1A et 1B représentent schématiquement un système automatique de tests d'endurance d'une pluralité d'éléments électriques conducteurs, conforme à l'invention,
- la figure 2 représente schématiquement en exemple un groupe d'éléments conducteurs reliés en série, qu'il est possible de tester grâce au système de l'invention,
- la figure 3 représente schématiquement en exemple un groupe d'éléments conducteurs reliés en parallèle, qu'il est possible de tester grâce au système de l'invention,
- la figure 4 représente schématiquement un générateur de courant utilisé dans le système de l'invention,
- la figure 5 est un chronogramme représentant des courants de tests fournis par le système de l'invention.

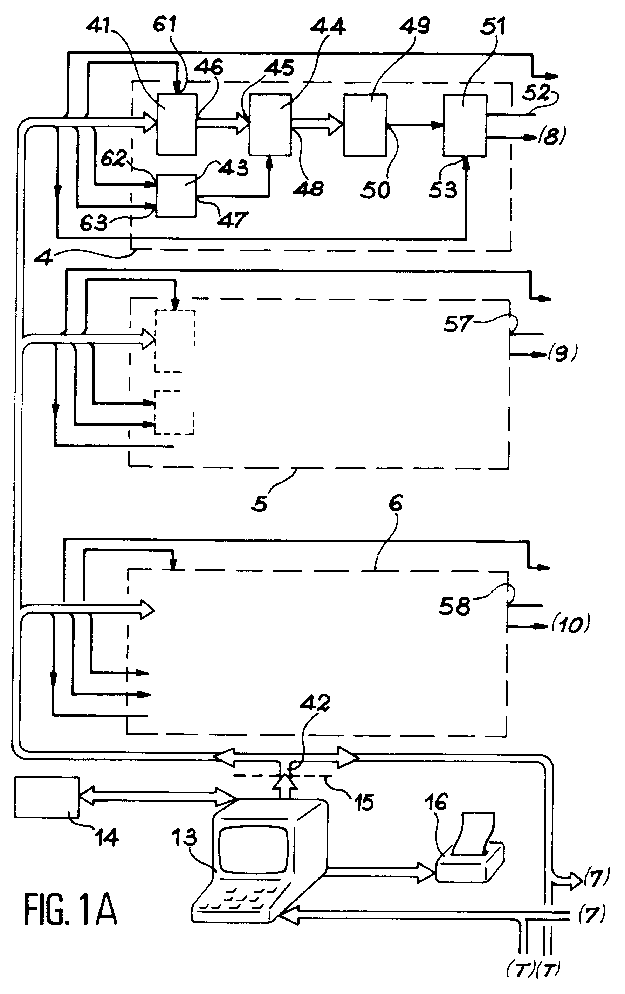

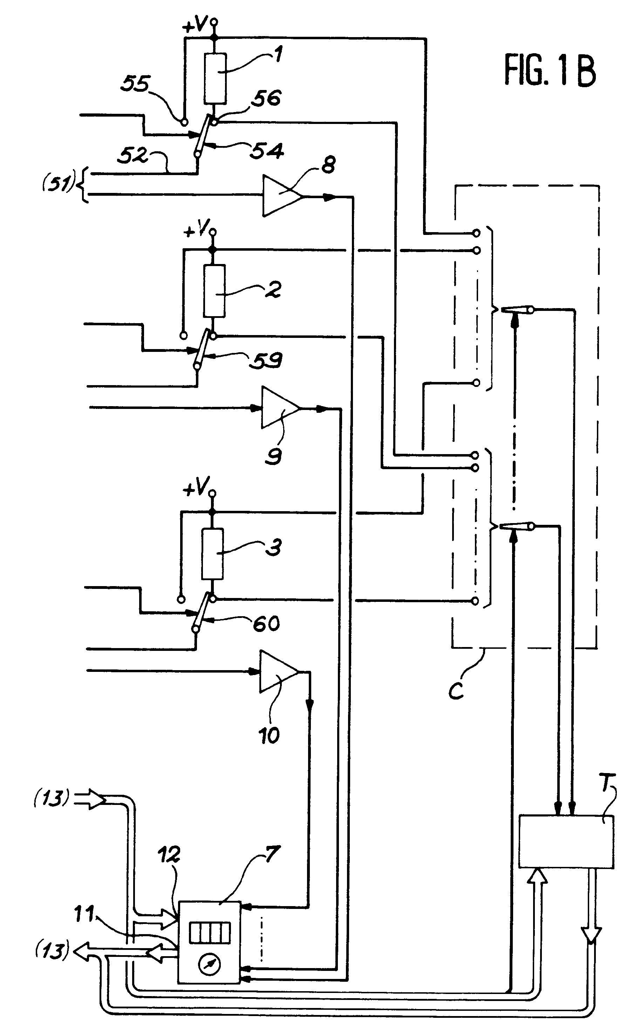

Les figures 1A et 1B représentent schématiquement un système automatique de tests d'endurance d'une pluralité d'éléments électriques conducteurs, conforme à l'invention. Ces éléments référencés 1, 2, 3 sur la figure et dont le nombre a été limité à 3 pour des commodités de représentation peuvent être, soit séparés les uns des autres, soit connectés entre eux pour former un ou plusieurs groupes séparés d'éléments, comme on le verra plus loin en détail. Il est évident que le nombre d'éléments ou de groupes d'éléments 1, 2, 3 qu'il est possible de tester à l'aide du système peut être plus élevé.

Le système comporte pour chaque élément ou chaque groupe d'éléments tel que 1, un générateur de courant réglable 4, relié à cet élément ou à ce groupe, pour lui appliquer, à partir d'un instant prédéterminé de départ, un courant de valeur prédéterminée réglable.

Les générateurs qui permettent d'alimenter les autres éléments 2, 3 sont respectivement représentés en 5, 6, de manière schématique.

Le système peut aussi comporter de façon avantageuse, pour l'ensemble des éléments ou groupe d'éléments, des moyens de lecture 7 de valeurs de courants. Les moyens de lecture 7 permettent de vérifier les valeurs de courants appliqués aux différents éléments.

Le système comprend en outre des moyens de mesure de tension aux bornes de chaque élément et/ou de courant appliqués à chaque élément. Les mesures de tension étant plus intéressantes, on a aussi représenté sur la figure 1 à titre indicatif des moyens de mesure de tension. Ces moyens de mesure de tension comprennent un voltmètre relié à chaque élément dont on veut mesurer la tension par un commutateur à balayage C. Ces moyens de mesure permettent de déterminer les évolutions respectives des valeurs de tension aux bornes les différents éléments. Le commutateur C et le voltmètre T sont commandés par des signaux de commande provenant du processeur 13. Les valeurs de tension mesurées sont enregistrées dans la mémoire 14 du processeur 13. Les courants ou tensions sont mesurés au cours du temps, à partir d'instants respectifs prédéterminés auxquels débute la circulation des courants dans ces éléments ou groupe d'éléments. Pour chaque élément, la mesure de la tension et ses bornes, ou du courant appliqué est arrêtée à un instant caractéristique qui correspond à une variation de la valeur mesurée, indiquant que cet élément se détériore, cette détérioration ne pouvant aller jusqu'à la rupture de la conduction. Les moyens de lecture 7 sont reliés, comme on le verra plus loin en détail, à un adaptateur d'impédance de sortie de chaque générateur, lui-même relié à l'élément testé. La liaison entre les moyens de lecture 7 et la sortie de chaque adaptateur d'impédance peut être réalisée par l'intermédiaire d'un amplificateur. Ces amplificateurs sont représentés en 8, 9, 10. Les moyens de lecture de courant 7 sont de type analogique ; ils sont respectivement reliés par des entrées aux sorties des amplificateurs 8, 9, 10. Ces moyens analogiques de lecture comportent une sortie numérique 11, ainsi qu'une entrée de commande 12.

Le système de l'invention comporte aussi un processeur 13 relié à une mémoire 14. Ce processeur est aussi relié par l'intermédiaire d'une interface 15, à l'entrée de commande 12 des moyens de lecture 7, à une entrée de commande du commutateur à balayage C, à une entrée de commande du voltmètre T, et aux générateurs de courants 4, 5, 6, qui correspondent respectivement aux éléments ou groupe d'éléments à tester 1, 2, 3.

Le processeur 13 peut être, de façon connue, muni d'un écran de visualisation et il peut être également relié à une imprimante 16 pour afficher par exemple les résultats de lecture de courants et/ou de mesure de tension.

La mémoire 14 contient des données de réglage des valeurs de courants fournis par les générateurs, des informations d'adressage de ces générateurs et de commande des moyens de mesures de tension T, du commutateur C, et des moyens de lecture 7, ainsi que d'autres informations de commande qui seront décrites plus loin en détail. Les informations de commande du voltmètre T permettent notamment de commander l'enregistrement dans la mémoire, des valeurs évolutives des tensions continues mesurées respectivement pour les éléments ou groupe d'éléments reliés aux générateurs. Ces mesures sont effectuées à partir des instants respectifs où ces tensions sont appliquées à ces éléments, jusqu'aux instants caractéristiques auxquels ces éléments ou groupe d'éléments se détériorent ou sont détruites.

Les courants qui sont fournis par chacun des générateurs peuvent être des courants continus ou des créneaux de courants. Selon l'invention, les lectures de courants et/ou les mesures de tension sont effectuées de préférence uniquement en courant et en tension continus.

On décrira plus loin la structure et le fonctionnement de chaque générateur de courant.

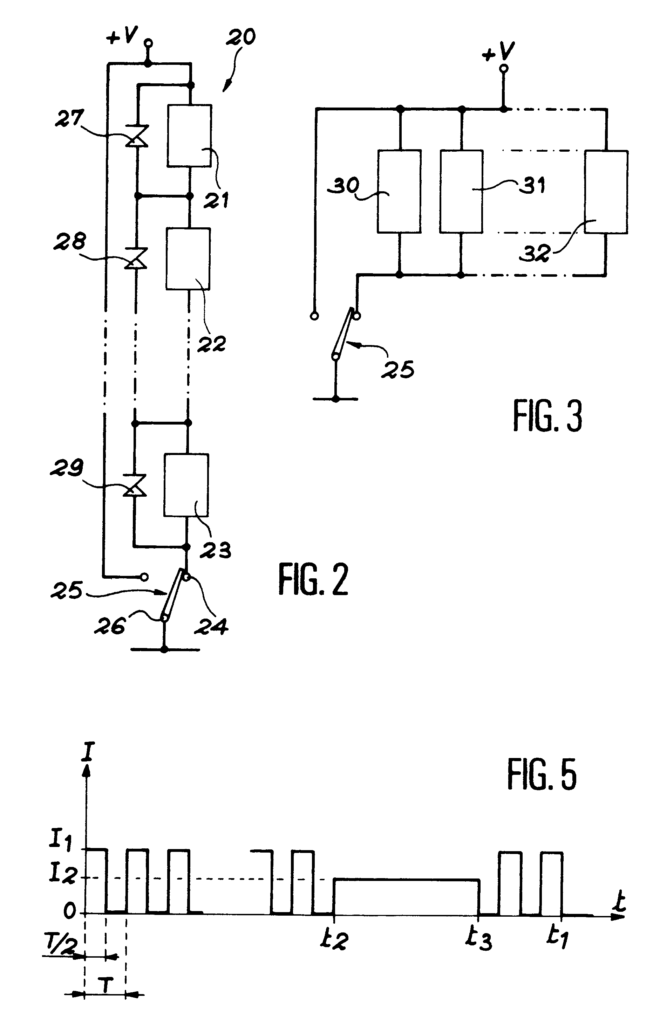

La figure 2 représente schématiquement un exemple d'un groupe 20 d'éléments 21, 22, 23, dont le nombre a été limité à 3 pour des commodités de représentation sur la figure, et qui peuvent être testés par le système de l'invention. Ces éléments sont ici reliés en série et le groupe qu'ils forment est relié entre la haute tension d'alimentation +V et une borne 24 d'un commutateur 25 de positions, dont le rôle sera expliqué plus loin en détail. Une borne d'alimentation 26 de ce commutateur est reliée à la sortie du générateur de courant correspondant.

Dans ce type de montage où les éléments sont disposés en série, des diodes de Zener 27, 28, 29 sont respectivement connectées en parallèle aux bornes des éléments 21, 22, 23. Dans ce cas et, de manière connue, lorsque l'un des éléments du groupe est détruit au cours du test d'endurance, le courant fourni par le générateur correspondant continue à circuler dans les autres éléments, grâce à la diode de Zener reliée en parallèle avec l'élément détruit.

La figure 3 représente un autre type de montage dans lequel les éléments 30, 31, 32 à tester sont reliés en parallèle pour former un groupe. Ces éléments sont reliés d'une part à une borne de haute tension +V et, d'autre part, au commutateur 25 décrit plus haut. Dans ce type de montage, la valeur du courant circulant dans l'ensemble des éléments du groupe subit une chute lorsque l'un des éléments est détruit lors du test d'endurance.

Dans ce cas, les moyens de mesure sont de façon avantageuse, des moyens de lecture de courant traversant chaque élément.

En se référant à nouveau à la figure 1, on va décrire maintenant de manière un peu plus détaillée l'un des générateurs de courant 4 utilisé dans le système de l'invention. Les autres générateurs étant identiques, on ne les a représentés que très schématiquement sur la figure.

Le générateur de courant 4 comprend une mémoire de courant 41 dans laquelle sont enregistrées les données correspondant à la valeur de courant prédéterminée, que l'on souhaite appliquer à l'élément ou au groupe d'éléments 1 correspondant. Cette mémoire est reliée au processeur 13, par l'intermédiaire d'un bus 42 et de l'interface 15, pour recevoir des informations d'adressage sur une entrée 61, et les données de valeur du courant provenant du bus 42. Ces informations et ces données permettent d'une part de sélectionner la mémoire 41 du générateur 4 et, d'autre part, d'enregistrer les données correspondant à la valeur du courant souhaité d'alimentation de l'élément 1 à tester. Il est évident que d'autres informations d'adressage correspondent à chacune des mémoires des autres générateurs 5, 6.

Le générateur 4 représenté figure 1 comporte aussi un générateur réglable de créneaux 43, relié au processeur 13 par des lignes du bus 42 et par l'interface 15. Ce générateur reçoit du processeur, sur une entrée 62, des informations d'adressage qui permettent de le sélectionner parmi les autres générateurs de créneaux. Ce générateur reçoit également sur une entrée 63, des données de réglage de la fréquence et du rapport cyclique des créneaux sélectionnés, dans le cas où on souhaite alimenter l'élément à tester 1, par des créneaux de courant. Le générateur de créneaux 43 ne sera pas décrit ici en détail, car il est d'un type connu dans l'état de la technique.

Le générateur de courant 4 comporte aussi un circuit logique 44 qui est relié par des entrées 45 à des sorties numériques 46 de la mémoire de courant 41. Ce circuit logique reçoit les données correspondant à la valeur du courant souhaité. Il est aussi relié à une sortie 47 du générateur de créneaux 43 pour recevoir les créneaux de fréquence et de rapport cyclique sélectionnés.

Le circuit logique 44 permet, comme on le verra plus loin en détail de fournir sur des sorties 48, les données provenant de la mémoire 48, correspondant à la valeur du courant souhaité, soit en continu, soit sous forme de créneaux dont la fréquence et le rapport cyclique sont fixés par le générateur de créneaux 47. Comme on le décrira plus loin, ce sont des données correspondant à un courant continu qui sont sélectionnées par le processeur pour être présentes à la sortie du circuit logique 44, pour toute lecture et/ou mesure de courant et/ou de tension. En effet, selon l'invention, tout test peut être effectué soit en appliquant un courant continu à l'élément ou au groupe d'éléments testés, soit en appliquant des créneaux de courant. Toutefois, dans le cas de créneaux de courant, les courants et/ou les tensions mesurés sont des courants et des tensions continus.

Le système de l'invention comprend aussi un convertisseur numérique-analogique 49 relié à des sorties 48 du circuit logique, pour fournir sur une sortie 50, soit un courant continu ayant la valeur souhaitée, déterminée par les données fournies par la mémoire 41, soit des créneaux de courant ayant une fréquence et un rapport cyclique fixés par les informations appliquées au générateur 43 par le processeur 13 et ayant un courant crête déterminé par les données de la mémoire 49.

Enfin, le système comporte un adaptateur d'impédance 51 qui est relié par une entrée à la sortie 50 du convertisseur 49. Cet adaptateur est aussi relié par une sortie 52 à l'élément ou groupe d'éléments 1 pour lui appliquer le courant continu de valeur souhaitée, ou les créneaux sélectionnés. L'adaptateur 51 comprend aussi des moyens de calibrage qui seront décrits plus loin en détail, sélectionnés par des informations de commande appliquées sur une entrée 53 et provenant du processeur 13.

En fait, chaque élément ou groupe d'élément 1 est relié à la sortie 52 de l'adaptateur, par un commutateur de sécurité 54 mentionné plus haut. Dans une première position 55, ce commutateur relie la sortie de l'adaptateur à la source de haute tension +V ; dans une deuxième position 56, il relie la sortie de l'adaptateur à une borne de l'élément ou groupe d'éléments à tester 1, dont une autre borne est reliée à la source de tension +V. Dans la position 55, l'élément 1 à tester est court-circuité et cette position est choisie lorsque l'on met en place l'élément 1 à tester, entre la borne 56 et la haute tension +V, pour éviter tout pic de tension au moment de cette mise en place. En effet, ce pic de tension pourrait endommager l'élément 1. Lorsque l'élément 1 doit être testé, le commutateur de sécurité 54 est dans la deuxième position 56. Le commutateur 54 est relié par une entrée de commande à une sortie de commande du processeur pour recevoir des signaux de commande le plaçant dans la première ou dans la deuxième position. Ces signaux de commande correspondent bien entendu à des informations enregistrées dans la mémoire du processeur 13.

De la même façon, les sorties 57 et 58 des générateurs 5, 6 sont respectivement reliées aux éléments ou groupe d'éléments 2, 3 à tester, par l'intermédiaire de commutateurs 59, 60.

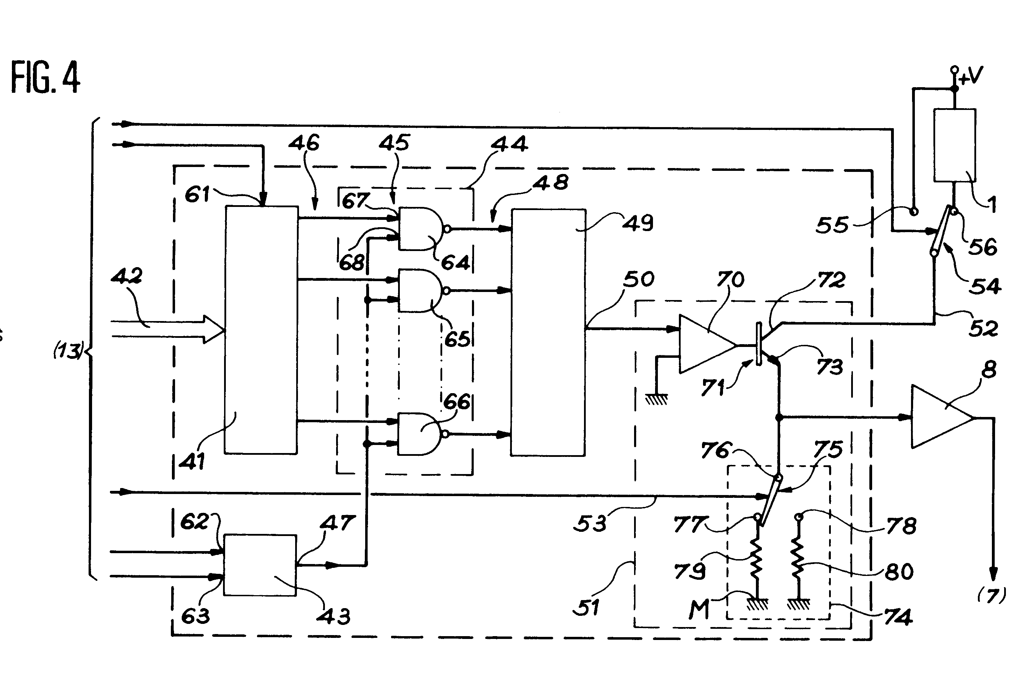

La figure 4 représente de manière encore plus détaillée le générateur 4 de la figure précédente. Les mêmes éléments portent les mêmes références sur cette figure et sur la figure 3.

On a représenté sur cette figure la mémoire 41 de courant reliée au bus 42 pour recevoir les données correspondant aux valeurs numériques du courant que l'on souhaite appliquer à l'élément ou groupe d'éléments 1. On a aussi représenté l'entrée d'adressage 61 qui permet de sélectionner la mémoire 41 parmi les mémoires des autres générateurs. Les sorties 46 de cette mémoire sont reliées aux entrées 45 du circuit logique 44 qui sera décrit plus loin en détail. Les sorties 48 du circuit logique sont respectivement reliées aux entrées du convertisseur numérique-analogique 49 dont la sortie est reliée à l'adaptateur d'impédance 51. On a également représenté sur cette figure l'élément ou groupe d'éléments à tester 1 relié à la source de haute tension +V ainsi qu'à la deuxième borne 56 du commutateur 54, ce commutateur étant positionné en 55 pendant la mise en place de l'élément 1.

On a aussi représenté sur cette figure l'amplificateur 8 relié à la sortie de l'adaptateur 51 ainsi qu'aux moyens 7 de lecture de courants. Enfin, on a aussi représenté le générateur de créneaux 43 qui fournit ces créneaux sur sa sortie 47. Ce générateur de courant est adressé comme indiqué plus haut, par des informations appliquées sur son entrée 62 et provenant du processeur 13. L'entrée 63 de ce générateur reçoit les informations de réglage de la fréquence et du rapport cyclique des créneaux fournis.

Le circuit logique 44 dont les sorties 48 sont reliées au convertisseur numérique-analogique 49, comportent une pluralité de portes de type "NON-ET" 64, 65, 66 à deux entrées. L'une des entrées telles que 67 de cette porte est reliée à une sortie correspondante de la mémoire 41 pour recevoir la valeur numérique mentionnée plus haut, tandis que l'autre entrée, telle que 68 de cette porte est reliée à la sortie 47 du générateur 43 de créneaux.

Lorsque l'on souhaite appliquer un courant continu à l'élément à tester 1, la sortie 47 du générateur de créneaux 43 ne fournit aucun signal. Il en résulte que toutes les entrées, telles que 68, des portes "NON-ET" du circuit 44 sont à l'état logique 1. La mémoire 41 de courant fournit sur ses sorties des signaux numériques d'état logique 0 ou 1, selon la veleur du courant continu souhaité. Il en résulte que les sorties des portes "NON-ET" du circuit 44 fournissent des valeurs numériques sur les sorties 48. Ces valeurs sont appliquées au convertisseur numérique-analogique 49 qui sur sa sortie 50, fournit un courant continu de valeur correspondante.

Au contraire, lorsque l'on souhaite appliquer des créneaux de courant à l'élément 1 à tester, les entrées telles que 67 des portes "NON-ET" du circuit 44 ont des niveaux logiques correspondant à ceux des sorties de la mémoire 41 qui dépendent de la valeur de courant crête souhaitée, tandis que les créneaux sont appliqués sur les autres entrées, telles que 68, de ces portes. Il en résulte que les sorties 48 du circuit logique 44 fournissent des créneaux de courant oscillant entre la valeur de courant crête et la valeur 0.

Ces créneaux sont présents sur la sortie 50 du convertisseur numérique-analogique 49.

La sortie 50 du convertisseur numérique-analogique 49 est reliée à l'entrée de l'adaptateur d'impédance 51. Cet adaptateur comprend un amplificateur inverseur 70 dont la sortie est reliée à la base d'un transistor 71 ; une première électrode, telle que le collecteur 72 par exemple de ce transistor, est reliée au commutateur de sécurité 54. Ce collecteur constitue la sortie 52 de l'adaptateur d'impédance 51. Une deuxième électrode 73, telle que l'émetteur par exemple est reliée à une tension de référence M par des moyens 74 de calibrage du courant circulant dans le transistor 71 et dans l'élément ou groupe d'éléments 1 correspondant. Les moyens de lecture 7 sont reliés à la deuxième électrode 73 par l'intermédiaire de l'amplificateur 8.

Les moyens de calibrage 74 comportent un commutateur 75 de sélection de calibre de courant. Ce commutateur comprend une première borne commune 76 qui est reliée à la première électrode 73 du transistor 71. Il comprend aussi deux autres bornes 77, 78 respectivement reliées à des résistances de calibrage 79, 80, elles-mêmes reliées à la tension de référence M. Le commutateur de sélection 75 est relié par une entrée de commande 53 à une sortie du processeur 13, par l'intermédiaire de l'interface 15 ; cette entrée de commande reçoit un signal de commande de sélection de l'une des résistances 79 ou 80 de calibrage. Ce signal de commande de sélection correspond bien entendu à des informations enregistrées dans la mémoire 14 du processeur 13. Cette sélection permet en fait de déterminer le calibre de lecture de courant souhaité.

En se référant à nouveau à la figure 1, on va maintenant décrire de manière plus détaillée les moyens de lecture 7. Ces moyens de lecture comportent un ampèremètre à entrée de mesures analogiques. Ces entrées sont respectivement reliées aux premières bornes 73 des moyens de calibrage 74 des courants circulant dans les différents éléments ou groupe d'éléments testés 1, 2, 3,... Cet ampèremètre comporte une sortie numérique 11 et une entrée de commande 12 qui sont reliées au processeur 13. L'entrée de commande 12 reçoit des signaux de sélection pour permettre de mesurer successivement les valeurs des courants respectifs circulant dans les éléments ou groupe d'éléments à tester ; lorsque les tests consistent à appliquer des créneaux de courants à certains des éléments à tester, pour les lectures ou mesures de courant et/ou de tension, on inhibe le générateur de créneaux 43 qui présente alors en sortie un signal de niveau logique 1. Pour ces lectures ou mesures, comme on le verra plus loin, on applique aux éléments, des courants continus.

Une horloge interne du processeur 13 permet d'enregistrer pour chaque élément testé, les différents instants de mesure. Cette horloge permet aussi d'enregistrer l'instant caractéristique qui, pour cet élément ou groupe d'éléments correspond à une variation du courant et/ou de tension mesuré et donc à la détérioration de cet élément.

La figure 5 est un chronogramme qui représente en exemple, l'intensité I en fonction du temps t du courant appliqué à l'élément ou au groupe d'éléments à tester. Dans cet exemple, on suppose que le courant appliqué à l'élément 1 est un courant en créneaux, d'amplitude crête I, de période T, de fréquence F et de rapport cyclique 1/2. Ces créneaux de courant sont appliqués en permanence depuis l'instant prédéterminé 0 par exemple, jusqu'à un instant t1 auquel l'élément cesse de conduire par suite de sa destruction. Les mesures de tension et/ou de courant en forme de créneaux de fréquence et de rapport cyclique réglables étant difficiles, on mesure périodiquement la valeur d'un courant continu tel que I2 circulant dans l'élément testé et/ou d'une tension continue correspondant à ce courant ; pour cela la mémoire 41 fournit sur ses sorties, entre des instants t₂ et t₃ , des valeurs numériques correspondant à ce courant continu de mesure, tandis que la sortie 47 du générateur 43 cesse de fournir des créneaux. Lors de la destruction de l'élément 1 ou de l'un des éléments du groupe 1, le courant I2 chute, indiquant ainsi cette destruction. Après chaque mesure avec un courant à continu, on applique de nouveau des créneaux de courant l'élément testé.

## Revendications

1. Système automatique de tests d'endurance d'une pluralité d'éléments électriques conducteurs (1, 2, 3,...), ces éléments pouvant être séparés les uns des autres ou connectés entre eux pour former un ou plusieurs groupes séparés d'éléments de ladite pluralité, comportant pour chaque élément ou chaque groupe (1) un générateur (4) réglable de courant relié à cet élément ou à ce groupe pour lui appliquer à partir d'un instant prédéterminé de départ, un courant de valeur prédéterminée réglable et, pour ces éléments ou ces groupes d'éléments, des moyens de lecture (7) des valeurs des courants et/ou de mesure des tensions appliqués à ces éléments ou ces groupes d'éléments pour déterminer les évolutions respectives de ces valeurs au cours du temps, à partir des instants respectifs prédéterminés jusqu'à des instants respectifs caractéristiques auxquels se produisent respectivement des variations de ces valeurs, caractérisé en ce qu'il comporte un processeur (13) relié à une mémoire (14), aux moyens de lecture et/ou de mesure (7) et aux générateurs (4, 5, 6,...) correspondant respectivement aux éléments ou aux groupes d'éléments, la mémoire (14) contenant des données de réglage des valeurs de courants fournis par les générateurs (4, 5, 6), des informations d'adressage de ces générateurs et de commande des moyens de lecture et/ou de mesure (7) pour permettre la mesure et l'enregistrement dans la mémoire de valeurs évolutives des courants et/ou des tensions mesurés respectivement pour ces éléments ou groupes d'éléments depuis les instants prédéterminés jusqu'auxdits instants caractéristiques respectifs, les courants appliqués aux éléments ou groupes d'éléments pouvant être continus ou en créneau, lesdits instants caractéristiques étant déterminés par le processeur qui détecte une variation entre des valeurs de courants et/ou de tensions mémorisées dans la mémoire (14) et les valeurs des courants et/ou de tensions fournies directement par les moyens de lecture et/ou de mesure (7), chaque générateur (4) comportant :
- au moins un générateur réglable de créneaux (43) relié au processeur (13) pour recevoir des informations d'adressage et des données de réglage de la fréquence et du rapport cyclique des créneaux sélectionnés,
chaque générateur comprenant :
- une mémoire de courant (41) contenant des données correspondant respectivement à la valeur de courant continu prédéterminée que l'on souhaite appliquer à l'élément ou au groupe (1) correspondant, cette mémoire étant reliée au processeur (13) pour recevoir des informations d'adressage et des données correspondant à la valeur de courant souhaité,
- un circuit logique (44) ayant des entrées respectivement reliées à des sorties de la mémoire de courant (41) pour recevoir lesdites données correspondant à la valeur du courant souhaité et relié à une sortie du générateur de créneaux (43) pour recevoir les créneaux sélectionnés, ce circuit logique (44) fournissant sur des sorties soit les données à la valeur du courant, soit en continu, soit en créneau suivant l'état des sorties du générateur de créneaux,
- un convertisseur numérique-analogique (49) relié à des sorties du circuit logique (44) pour fournir sur une sortie (50), soit un courant continu de valeur souhaitée, soit des créneaux sélectionnés de courant de valeur souhaitée,
- un adaptateur (51) d'impédance relié par une entrée à la sortie du convertisseur (49) et relié par une sortie à l'élément (1) ou au groupe correspondant pour lui appliquer le courant continu de valeur souhaitée ou les créneaux sélectionnés de valeur souhaitées.

2. Système selon la revendication 1, caractérisé en ce que chaque élément ou groupe d'éléments (1) est relié à la sortie de l'adaptateur d'impédance (51) par un commutateur de sécurité (54) qui, dans une première position (55), relie la sortie de l'adaptateur (51) à une source de haute tension (+V), pendant la mise en place de l'élément ou groupe d'éléments qui doit être relié à la source de haute tension et à la sortie de l'adaptateur pour un test, ce commutateur de sécurité reliant, dans une deuxième position (54), la sortie de l'adaptateur avec l'élément ou groupe d'éléments, au moment du test, et étant lui-même relié à une sortie de commande du processeur (13) pour recevoir des signaux de commande le plaçant dans la première ou la deuxième position, ces signaux correspondant à des informations enregistrées dans la mémoire (14) du processeur (13).

3. Système selon la revendication 2 caractérisé en ce que l'adaptateur d'impédance (51) comprend un amplificateur (70) relié à la sortie du convertisseur numérique-analogique (49) et à la base d'un transistor (71) dont une première électrode (72) est reliée au commutateur de sécurité (54) et constitue la sortie de l'adaptateur d'impédance, une deuxième électrode (73) de ce transistor étant reliée à une tension de référence (M) par des moyens de calibrage (74) du courant circulant dans le transistor et dans L'élément ou groupe d'éléments (1) correspondant.

4. Système selon la revendication 3, caractérisé en ce que les moyens de calibrage comportent un commutateur de sélection de calibres dont une première borne est reliée à la première électrode, ce commutateur ayant deux autres bornes de calibrage reliées respectivement à des résistances de calibrage elles-mêmes reliées à la tension de référence, le commutateur de sélection étant relié par une entrée de commande à une sortie du processeur pour recevoir un signal de commande de sélection de l'une des résistances de calibrage, ce signal de commande de sélection correspondant à des informations enregistrées dans la mémoire du processeur.

5. Système selon la revendication 1, caractérisé en ce qu'il comporte des moyens de lecture de courant à entrées de mesures analogiques reliées respectivement aux premières bornes des moyens de calibrage (74) correspondant aux éléments ou groupes d'éléments, ces moyens de lecture ayant une sortie numérique et une entrée de commande reliées au processeur, cette entrée de commande recevant des signaux de sélection pour mesurer successivement les valeurs des-courants respectifs appliqués aux éléments ou groupes d'éléments.

6. Système selon la revendication 1, caractérisé en ce que les moyens de mesure de tension comportent un voltmètre (T) à entrées de mesure analogiques relié à chaque élément ou groupe d'éléments par un commutateur (C) à balayage ayant une entrée de commande reliée au processeur (13), cette entrée recevant des signaux de sélection d'un élément ou groupe d'éléments pour relier le voltmètre successivement aux bornes des différents éléments groupes d'éléments, le voltmètre comportant une sortie numérique reliée au processeur (13) pour enregistrer successivement dans la mémoire les valeurs des tensions mesurées respectivement aux bornes des éléments ou groupes d'éléments, une horloge interne du processeur (13) permettant d'enregistrer ledit instant prédéterminé de départ, et des instants de mesure de tensions pour chaque élément, ce processeur enregistrant l'instant prédéterminé caractéristique pour chaque élément ou groupe d'éléments.

## Patentansprüche

1. Automatisches Dauertestsystem einer Vielzahl elektrisch leitender Elemente (1, 2, 3,...), wobei diese Elemente voneinander getrennt sein können oder miteinander verbunden sein können, um eine oder mehrere getrennte Gruppen von Elementen der genannten Vielzahl zu bilden, umfassend für jedes Element oder jede Gruppe (1) einen regelbaren Stromgenerator (4), verbunden mit diesem Element oder dieser Gruppe, um in dieses Element oder diese Gruppe ab einem vorher festgelegten Anfangszeitpunkt einen Strom mit einem vorher festgelegten, regelbaren Wert einzuspeisen und, für diese Elemente oder diese Elementegruppen, Leseeinrichtungen (7) der Stromwerte und/oder zur Messung der an diese Elemente oder diese Elementegruppen gelegten Spannungen, um die jeweiligen Entwicklungen dieser Werte zeitlich zu ermitteln, von jeweils vorher festgelegten Zeitpunkten bis zu jeweils charakteristischen Zeitpunkten, in denen sich jeweils Veränderungen dieser Werte ereignen,
**dadurch gekennzeichnet,**
daß es einen Prozessor (13) umfaßt, verbunden mit einem Speicher (14), mit Lese- und/oder Meßeinrichtungen (7) und mit Generatoren (4, 5, 6,...), jeweils Elementen oder Elementegruppen entsprechend, wobei der Speicher (14) Regelungsdaten der Werte der durch die Generatoren (4, 5, 6,...) gelieferten Ströme und Informationen zur Adressierung dieser Generatoren und zur Steuerung der Lese- und/oder Meßeinrichtungen (7) enthält, um die Messung zu ermöglichen und die Speicherung der sich entwickelnden Werte der gemessenen Ströme und/oder Spannungen in dem Speicher für diese Elemente oder Elementegruppen, ab den vorher festgelegten Zeitpunkten bis zu den jeweiligen charakteristischen Zeitpunkten, wobei die an die Elemente oder Elementegruppen gelegten Ströme Gleich- oder Rechteckimpulsströme sein können, wobei die charakteristischen Zeitpunkte festgelegt werden durch den Prozessor, der eine Variation feststellt zwischen den im dem Speicher (14) aufgezeichneten Strom- und/oder Spannungswerten und den Strom- und/oder Spannungswerten, die direkt von den Lese- und/oder Meßeinrichtungen (7) geliefert werden, wobei jeder Generator (4) enthält:
- wenigstens einen regelbaren Rechteckimpulsgenerator (43), verbunden mit dem Prozessor (13), um Adressierungsinformationen zu erhalten und Regelungsdaten der Frequenz und des zyklischen Verhältnisses der ausgewählten Rechteckimpulse,
jeder Generator umfaßt:
- einen Strom-Speicher (41), der Daten enthält, die jeweils dem vorher festgelegten Wert des Gleichstroms entsprechen, den man an das entsprechende Element oder die entsprechende Elementegruppe (1) legen will, wobei dieser Speicher verbunden ist mit dem Prozessor (13), um Adressierungsinformationen und dem Wert des gewünschten Stroms entsprechende Daten zu erhalten,
- eine logische Schaltung (44) mit Eingängen, jeweils verbunden mit Ausgängen des Strom-Speichers (41), um die genannten, dem Wert des gewünschten Stroms entspechenden Daten zu erhalten, und verbunden mit einem Ausgang des Rechteckimpulsgenerators (43), um die ausgewählten Rechteckimpulse zu erhalten, wobei diese logische Schaltung (44) an ihren Ausgängen die Stromwertdaten entweder als Gleich- oder als Rechteckimpulsstrom liefert, je nach dem Zustand der Ausgänge des Rechteckimpulsgenerators,
- einen Digital-Analog-Umsetzer (49), verbunden mit Ausgängen der logischen Schaltung (44), um auf einem Ausgang (50) entweder einen Gleichstrom mit dem gewünschten Wert zu liefern, oder Rechteckstromimpulse mit dem gewünschten Wert,
- eine Impedanzenanpassungsschaltung (51), verbunden durch einen Eingang mit dem Ausgang des Umsetzers (49) und verbunden durch einen Ausgang mit dem entsprechenden Element (1) oder mit der entsprechenden Gruppe, um den Gleichstrom des gewünschten Werts oder die ausgewählten Rechteckimpulse des gewünschten Werts anzulegen.

2. System nach Anspruch 1, dadurch gekennzeichnet, daß jedes Element oder jede Elementegruppe (1) verbunden ist mit dem Ausgang der Impedanzenanpassungs-schaltung (51) über einen Sicherheitsumschalter (54), der, in einer ersten Stellung (55), den Ausgang der Anpassungsschaltung (51) verbindet mit einer Hochspannungsquelle (+V) während der Anbringung des Elements oder der Elementegruppe, das bzw. die verbunden werden soll mit der Hochspannungsquelle und mit dem Ausgang der Anpassungsschaltung für einen Test, wobei dieser Sicherheitsumschalter in einer zweiten Stellung (56) den Ausgang der Anpassungsschaltung verbindet mit dem Element oder der Elementegruppe, im Moment des Tests, und selbst verbunden ist mit einem Steuerausgang des Prozessors (13), um Steuersignale zu erhalten, die ihn in die erste oder zweite Stellung schalten, wobei diese Signale Informationen entsprechen, die gespeichert sind in dem Speicher (14) des Prozessors (13).

3. System nach Anspruch 2, dadurch gekennzeichnet, daß die Impedanzenanpassungsschaltung (51) einen Verstärker (70) umfaßt, verbunden mit dem Ausgang des Digital-Analog-Umsetzers (49) und mit der Basis eines Transistors (71), dessen erste Elektrode (72) verbunden ist mit dem Sicherheitsumschalter (54) und den Ausgang der Impedanzenanpassungsschaltung bildet, wobei eine zweite Elektrode (73) dieses Transistors verbunden ist mit einer Bezugsspannung (M) über Kalibriereinrichtungen (74) des Stroms, der in dem Transistor und dem entsprechenden Element oder der entsprechenden Elementegruppe (1) fließt.

4. System nach Anspruch 3, dadurch gekennzeichnet, daß die Kalibriereinrichtungen einen Kaliberwahl-Umschalter umfassen, dessen erster Anschluß verbunden ist mit der ersten Elektrode, wobei dieser Umschalter zwei weitere Kalibrieranschlüsse hat, jeweils verbunden mit Kalibrierwiderständen, selbst verbunden mit der Bezugsspannung, wobei der Wahlumschalter durch einen Steuereingang verbunden ist mit einem Ausgang des Prozessors, um ein Auswahl-Steuersignal für einen der Kalibrierwiderstände zu erhalten, wobei dieses Auswahl-Steuersignal Informationen entspricht, die gespeichert sind in dem Speicher des Prozessors.

5. System nach Anspruch 1, dadurch gekennzeichnet, daß es Leseeinrichtungen mit Analogmeßeingängen umfaßt, jeweils verbunden mit den ersten Anschlüssen der Kalibriereinrichtungen (74), den Elementen oder Elementegruppen entsprechend, wobei diese Leseeinrichtungen einen Digitalausgang haben und einen mit dem Prozessor verbundenen Steuereingang, wobei dieser Steuereingang Auswahlsignale erhält, um nacheinander die Werte der jeweils an die Elemente oder Elementegruppen gelegten Ströme zu messen.

6. System nach Anspruch 1, dadurch gekennzeichnet, daß die Spannungsmeßeinrichtungen einen Voltmeter (T) umfassen mit Analogmeßeingängen, verbunden mit jedem Element oder jeder Elementegruppe durch einen Abfrage-Umschalter mit einem Steuereingang, verbunden mit dem Prozessor (13), wobei dieser Eingang Auswahlsignale eines Elements oder einer Elementegruppe erhält, um das Voltmeter nacheinander mit den Anschlüssen der verschiedenen Elemente oder Elementegruppen zu verbinden, wobei das Voltmeter einen Digitalausgang enthält, verbunden mit dem Prozessor (13), um nacheinander in dem Speicher die Werte der jeweils an den Anschlüssen der Elemente oder Elementegruppen gemessenen Spannungen zu speichern, wobei eine interne Uhr des Prozessors (13) erlaubt, den genannten, vorher festgelegten Anfangszeitpunkt zu speichern und Spannungsmessungszeitpunkte für jedes Element, wobei dieser Prozessor den charakteristischen, vorher festgelegten Zeitpunkt für jedes Element oder jede Elementegruppe speichert.

## Claims

1. Automatic system for endurance tests of a plurality of conducting electrical elements (1, 2, 3, etc), these elements possibly being separated from one another or connected together to form one or more separate groups of elements of the said plurality, including, for each element or each group (1), an adjustable current generator (4) linked to this element or to this group in order to apply a current of adjustable predetermined value to it from a predetermined start instant, and, for these elements or these groups of elements, means (7) of reading the values of the currents and/or of measuring the voltages applied to these elements or these groups of elements in order to determine the respective evolutions of these values over time, from predetermined respective instants up to characteristic respective instants at which variations in these values respectively occur, characterized in that it includes a processor (13) linked to a memory (14), to the reading and/or measuring means (7) and to the generators (4, 5, 6, etc) corresponding respectively to the elements or to the groups of elements, the memory (14) containing data for adjusting the values of currents supplied by the generators (4, 5, 6), information for addressing these generators and for control of the reading and/or measuring means (7) in order to allow the measuring and the recording in the memory of evolving values of the currents and/or of the voltages measured respectively for these elements or groups of elements from the predetermined instants up to the said respective characteristic instants, the currents applied to the elements or groups of elements possibly being continuous or in square waves, the said characteristic instants being determined by the processor which detects a variation between current and/or voltage values stored in the memory (14) and the current and/or voltage values supplied directly by the reading and/or measuring means (7), each generator (4) including:
- at least one adjustable square-wave generator (43) linked to the processor (13) for receiving addressing information and data on adjusting the frequency and the duty cycle of the selected square waves,
- a current memory (41) containing data corresponding respectively to the predetermined continuous current value which it is desired to apply to the corresponding element or the group (1), this memory being linked to the processor (13) in order to receive addressing information and data corresponding to the desired current value,
- a logic circuit (44) having inputs linked respectively to outputs of the current memory (41) in order to receive the said data corresponding to the value of the desired current and linked to a square wave generator output (43) for receiving the selected square waves, this logic circuit (44) supplying on outputs, either the data with the value of the current, either in continuous mode, or in square waves according to the status of the outputs of the square wave generator,
- a digital/analog converter (49) linked to outputs of the logic circuit (44) in order to supply, on an output (50), either a continuous current of desired value, or selected square waves of desired current value,
- an impedence matching circuit (51) linked by one input to the output of the converter (49) and linked by an output to the element (1) or to the corresponding group in order to apply to it the continuous current of desired value or the selected square waves of desired value.

2. System according to Claim 1, characterized in that each element or group of elements (1) is linked to the output of the impedance matching circuit (51) by a safety switch (54) which, in a first position (55), links the output of the matching circuit (51) to a high-voltage source (+V), while the element or group of elements which is to be linked to the high-voltage source is put in place, and to the output of the matching circuit for a test, this safety switch, in a second position (54), linking the output of the matching circuit with the element or group of elements, at the moment of the test, and being itself linked to a control output of the processor (13) in order to receive control signals placing it in the first or the second position, these signals corresponding to information recorded in the memory (14) of the processor (13).

3. System according to Claim 2, characterized in that the impedance matching circuit (51) comprises an amplifier (70) linked to the output of the digital/analog converter (49) and to the base of a transistor (71), a first electrode (72) of which is linked to the safety switch (54) and constitutes the output of the impedance matching circuit, a second electrode (73) of this transistor being linked to a reference voltage (M) by means (74) for calibrating the current flowing in the transistor and in the element or corresponding group of elements (1).

4. System according to Claim 3, characterized in that the calibration means comprise a calibration selection switch, a first terminal of which is linked to the first electrode, this switch having two other calibration terminals linked respectively to calibration resistors which are themselves linked to the reference voltage, the selection switch being linked by a control input to an output of the processor in order to receive a control signal for selection of one of the calibration resistors, this selection control signal corresponding to information recorded in the memory of the processor.

5. System according to Claim 1, characterized in that it includes current reading means with analog measuring inputs linked respectively to the first terminals of the calibration means (74) corresponding to the elements or groups of elements, these reading means having a digital output and a control input linked to the processor, this control input receiving selection signals for successively measuring the values of the respective currents applied to the elements or groups of elements.

6. System according to Claim 1, characterized in that the voltage measuring means include a voltmeter (T) with analog measuring inputs linked to each element or group of elements by a scanning switch (C) having a control input linked to the processor (13), this input receiving signals for selection of an element or group of elements in order to link the voltmeter successively to the terminals of the various elements or groups of elements, the voltmeter including a digital output linked to the processor (13) for recording successively in the memory the values of the voltages measured respectively at the terminals of the elements or groups of elements, an internal clock of the processor (13) making it possible to record the said predetermined start instant, and voltage measuring instants for each element, this processor recording the characteristic predetermined instant for each element or group of elements.
